# EUROPEAN PATENT SPECIFICATION

(11) **EP 3 961 658 B1**
(45) Date of publication and mention of the grant of the patent: **16.08.2023**
(21) Application number: 19957334.6
(22) Date of filing: 26.12.2019
(51) Int. Cl.: H10N 60/01, H01B 12/02

(54) **BLANK FOR PRODUCING A LONG NB3 SN-BASED SUPERCONDUCTING WIRE**
ROHLING ZUR HERSTELLUNG EINES LANGEN SUPRALEITENDEN DRAHTES AUF NB3-SN-BASIS
EBAUCHE POUR PRODUIRE UN CONDUCTEUR SUPRACONDUCTEUR DE GRANDE LONGUEUR À BASE DE NB3 SN

(43) Date of publication of application: 02.03.2022
(73) Proprietor: Joint-Stock Company "TVEL", Moscow 115409 (RU)
(72) Inventor: ABDYUKHANOV, Ildar Mansurovich, Moscow, 129323 (RU); ALEKSEEV, Maxim Viktorovich, Mytischi,, 141006 (RU); SILAEV, Alexander Gennadievich, Moscow, 123098 (RU); PANTSYRNY, Viktor Ivanovich, Moscow, 123098 (RU); MAREEV, Konstantin Alekseevich, Moscow, 121059 (RU); KRYLOVA, Mariia Vladimirovna, Moscow, 117148 (RU); TSAPLEVA, Anastasiia Sergeevna, Schelkovo, 141100 (RU); KONOVALOV, Pavel Vladimirovich, Moscow, 115487 (RU); ZERNOV, Sergei Mihailovich, Moscow, 111398 (RU)
(74) Representative: Yalçiner Patent and Consulting Ltd.
(86) International application number: PCT/RU2019/001022
(87) International publication number: WO 2021/133193

(56) References cited:
- EP-A1- 1 903 620
- WO-A1-2019/132698
- WO-A1-2019/173593
- WO-A1-2019/173593
- WO-A2-2015/175064
- RU-C2- 2 507 636
- RU-C2- 2 546 136

## Description

### TECHNICAL FIELD

The invention relates to the field of electrical engineering and the creation of long composite wires based on superconducting compounds for use in the manufacture of electrical equipment.

### BACKGROUND

State-of-the-art development of high energy physics devices requires creation of superconductive materials with high current carrying capacity in magnetic fields up to 16 T. It is known that superconductor critical current density depends on, among other things, defects of the crystalline structure, namely: density of grain boundaries, quantity of particles of the second phases of nanometric size, admixtures, etc. The more of them there are, the higher is the density of current flowing along the superconductor. One of the methods to create defects, distortions of the crystalline grid, form phases of nanometric size, etc. is alloying.

Recently, the method of internal oxidation is used to increase the quantity of the nanosize particles in the superconductive layer. For this purpose the following elements in the superconductor design: rods, tubes, which were made of pure niobium, are made of Nb-Zr alloy, and oxide powders are introduced as alloying elements, for example, into a tin source. In process of diffusion annealing of the conductor of final size, oxygen contained in the oxide powder reacts with zirconium to form a zirconium oxide. Particles of such oxide usually have nanosizes and may be arranged both in the body and along the boundaries of Nb3 Sn grains. It is demonstrated that presence of zirconium oxide parties in the superconductive layer makes it possible to increase density of the critical current in the superconductive layer in the magnetic field of 12 T at temperature of 4.2K to 9600 A/MM2 [" Internally oxidized Nb3Sn strands with fine grain size and high critical current density", X. Xu, M.D. Sumption, X. Peng, Adv. Mater. 2015, 27, 1346-1350 ].

There is a known blank for producing a composite Nb3 Sn-based superconductive wire ( EP 2717340, published in 2014 ), comprising a copper-containing matrix, in the center of which there is a tin-containing rod, surrounded with multiple niobium-containing rods in a copper-containing shell, a copper jacket and a diffusion barrier, besides, the copper-containing matrix and the copper-containing shell contain tin.

When the indicated blank of the superconductive wire is manufactured in process of intermediate operations, for example, hot pressing, intermetallic compounds of niobium and tin may be formed at the boundary of the niobium-containing rod with the copper-containing cladding. During further drawing of such blank, particles of such compound will be stress concentrators and will cause damage of elements and the wire as a whole. Besides, formation of non-superconductive intermetallide compounds at the boundary of niobium-containing rods with the cladding will prevent formation of the Nb3 Sn superconductive compound and reduce current carrying capacity of the superconductive wire as a whole.

There is a known superconductive multi-filament Nb3 Sn wire stabilized with zirconium ( US 2003/0168246 A1, published in 2003 ), made of multiple filaments, each comprising multiple Nb3 Sn grains, which have many distributed ZrO2 particles and placed in a metal matrix, which has electrical conductivity at temperature below 77 K, and the thermal expansion ratio is the same or higher than in Nb3 Sn. In this wire high current carrying capacity is achieved by increased number of pinning centers, which are ZrO2 particles. This mechanism works in middle magnetic fields of up to 12 T. To obtain high current carrying capacity in magnetic fields of more than 12 T, it is necessary to increase the upper critical field of the superconductor. Typically, with this purpose the superconductive compound is doped with tantalum and/or titanium. In the described wire there is no joint alloying of the superconductive layer comprising multiple Nb3 Sn grains, zirconium together with tantalum and/or titanium, which will not make it possible to achieve high current carrying capacity of the conductor in intense magnetic fields.

The closest to the proposed technical solution is a blank for producing a Nb3 Sn-based superconductive wire by the method of internal tin source [" Results on mono element internal tin Nb3Sn conductors (MEIT) with Nb7.5Ta and Nb (lZr + Ox) filaments", Bruce A. Zeitlin, Eric Gregory, Jud Marte, Mark Benz, Tae Pyon et al., IEEE Transaction on applied superconductivity, vol. 15, No. 2, 2005], which consists of a copper matrix, in the centre of which there is a tin-containing rod, around which there are multiple rods of Nb ally - 1 wt.% Zr, each with a copper cladding, a multi-layer niobium barrier and a copper jacket. A tin source is a rod made of alloy Sn-Ti, Sn-Cu or Sn-SnO.

Double doping of Nb3 Sn superconductive layer with zirconium and titanium, even if there are no particles of zirconium oxide in the superconductive phase, makes it possible to obtain the highest density of the critical current in the conductor after annealing at 700 °C. However, production of Sn-Ti alloy and its subsequent deformation is a complex task, because tin and titanium form intermetallide compounds, which represent brittle hard particles. Size and distribution of such particles are hard to control both in process of alloy melting and making rods therefrom. This may cause uneven alloying of the Nb3 Sn superconductive layer with titanium and reduction of its critical current. Besides, the presence of large intermetallide particles of tin and titanium compound may break the wire when it is drawn.

Another patent document EP1903620A1 discloses Nb3Sn superconducting wire and precursor. In said patent document, the precursor for fabricating a Nb3Sn superconducting wire by an internal Sn process includes one or a plurality of stabilizing copper portions collectively disposed in the center, each stabilizing copper portion being provided with a diffusion barrier layer in the periphery thereof, and a superconducting matrix portion disposed so as to surround the one or the plurality of stabilizing copper portions, the superconducting matrix portion including a Nb or Nb-based alloy core and a Sn or Sn-based alloy core embedded in a Cu or Cu-based alloy matrix.

In patent document WO2019173593A1 diffusion barriers for metallic superconducting wires are disclosed. The superconducting wires incorporate diffusion barriers composed of Nb alloys or Nb-Ta alloys that resist internal diffusion and provide superior mechanical strength to the wires.

In patent document WO2015175064A2, superconducting wires and methods of making thereof are disclosed. The superconducting wires can comprise a metallic matrix and at least one continuous subelement embedded in the matrix. Each subelement can comprise a non-superconducting core, a superconducting layer coaxially disposed around the non-superconducting core, and a barrier layer coaxially disposed around the superconducting layer. The superconducting layer can comprise a plurality of Nb3Sn grains stabilized by metal oxide particulates disposed therein. The Nb3Sn grains can have an average grain size of from 5 nm to 90 nm (for example, from 15 nm to 30 nm). The superconducting wire can have a high-field critical current density (J c ) of at least 5,000 A/mm2 at a temperature of 4.2 K in a magnetic field of 12 T. Also described are superconducting wire precursors that can be heat treated to prepare superconducting wires, as well as methods of making superconducting wires.

Another patent document WO2019032698A1 discloses an energy collector containing an absorber and a working fluid. The working fluid is held in a state of two-phase equilibrium to minimize sensible heating and thus heat losses to the environment. The energy collector may be held under a vacuum to further prevent heat losses to the ambient environment. One or more energy collectors may be connected to other energy collectors, end uses, or thermal energy storage.

### DISCLOSURE OF THE INVENTION

The objective is to produce a blank to produce a long Nb3 Sn-based superconductive composite wire by the method of internal tin source with high current carrying capability for use in various magnetic systems with a flux density greater than 12 T.

The technical result is ensuring high current carrying capability in the long Nb3 Sn-based superconductive composite wire in magnetic fields with flux density greater than 12 T produced in accordance with the developed method.

The technical result is achieved in the blank for producing a long Nb3 Sn-based superconductive wire, consisting of a copper jacket, inside which there is a copper matrix having a tin-containing rod at its centre with a plurality of copper-clad rods arranged therearound, wherein the copper matrix is surrounded by a multilayer niobium barrier, characterized in that the plurality of rods consists of rods containing an Nb-Ti alloy and rods made of an Nb-Zr alloy, wherein each rod made of an Nb-Zr alloy being a composite made from Nb-Zr alloy in the form of a core surrounded by a niobium barrier.

In a particular embodiment the rods of Nb-Zr alloy are arranged around the tin-containing core and along the inner side of the diffusion barrier.

In a particular embodiment the diffusion barrier consists of two layers, besides, the internal layer is made of niobium alloy, and the outer layer is made of niobium.

In a particular embodiment the diffusion barrier consists of two layers, besides, the internal layer is made of niobium, and the outer layer is made of niobium alloy.

Therefore, using plurality of rods containing Nb-Ti alloy and rods of Nb-Zr alloy in the form of a core surrounded by the niobium barrier in the blank design makes it possible to alloy the superconductive layer jointly with titanium and zirconium. According to the literature data [Superconducting critical temperatures, critical magnetic fields, lattice parameters, and chemical compositions of "bulk" pure and doped Nb3 Sn produced by the bronze process, M. Suenaga, D. O. Welch, R. L. Sabatini, O. F. Kammerer, and S. Okuda, J. Appl. Phys. 59, 840 (1986); doi: 10.1063/1.336607] alloying of Nb3 Sn layer with zirconium and titanium makes it possible to increase the upper critical field of the superconductor as a whole, which also means increase of its critical current in the intense fields. In connection therewith, use of two types of rods, one of which is doped with titanium, and the other one with zirconium makes it possible to increase the current carrying capacity of the superconductor as a whole.

Arrangement of rods from Nb-Zr alloy in the copper matrix around the tin-containing rod makes it possible to reduce the share of the large-grain Nb3 Sn layer, therefore, to increase the density of the grain boundaries in the superconductive compound and density of the conductor's critical current as a whole. Arrangement of Nb-Zr alloy rods along the internal surface of the diffusion barrier makes it possible to reduce the share of the columnar Nb3 Sn grains, the element composition of which is not stoichiometric, and therefore to increase the current carrying capacity.

Use of a double-layer barrier, the inner layer of which is made of niobium alloy, makes it possible to change the kinetics of superconductive layer formation, its grain structure and to increase the current carrying capacity of the superconductor.

The proposed invention is explained with drawings.

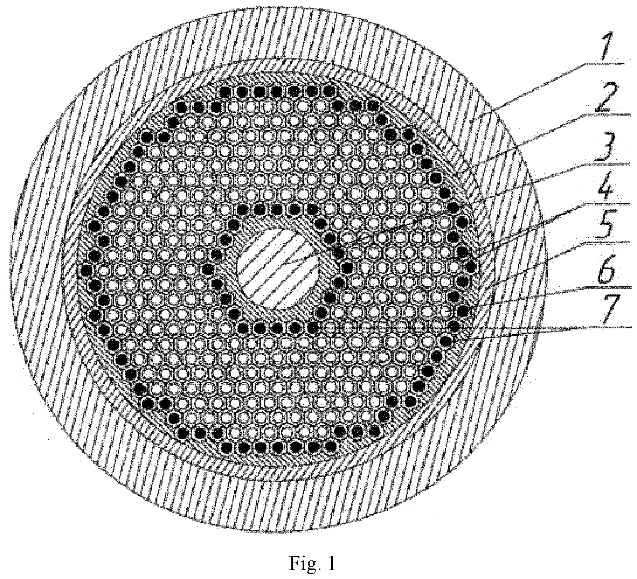

Fig. 1 represents the cross-section of the blank. Each blank comprises a copper jacket 1, inside of which there is a copper matrix 2, in the center of which there is a tin-containing rod 3, a plurality of copper-clad rods 4 arranged therearound, besides, the copper matrix 2 is surrounded with a multi-layer niobium diffusion barrier 5. Multiple rods consist of rods 6, containing Nb-Ti alloy and rods 7 of Nb-Zr alloy.

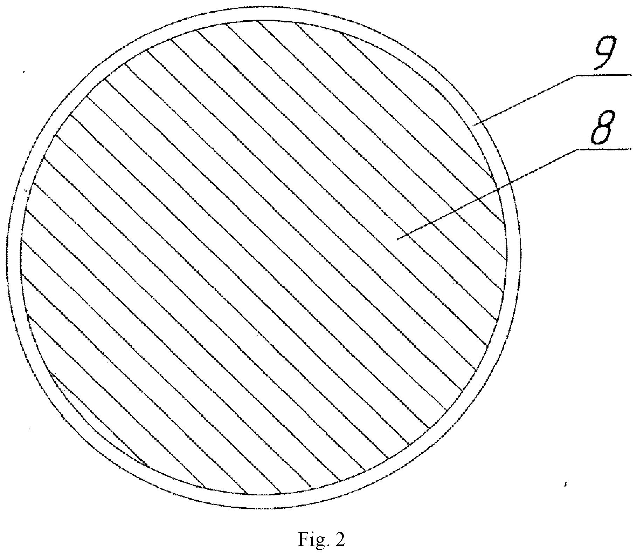

Fig. 2 presents the cross section of the rod 7 of Nb-Zr alloy. Each rod 7 is a composite made of Nb-Zr alloy in the form of a core 8 surrounded by a niobium barrier 9.

IMPLEMENTATION OF INVENTION Example.

To make the rod of Nb-Zr alloy, an assembly was made consisting of the Nb-Zr rod, the niobium barrier, and the copper cladding. The resulting blank was extruded using a hydraulic pipe and rod press PA-653 from a container with a diameter of a working bushing of 100 mm into a rod with diameter of 46 mm. The extruded rod representing a composite was deformed to a hexagon with "turnkey" size of 3.2 mm. The produced hexagonal rods were cut into measured parts to produce Nb-Zr alloy rods.

When the blank for producing the Nb3 Sn-based superconductive wire is made, the rods of Nb-Zr alloy in the quantity of 144 pcs and rods containing Nb-Ti alloy in the quantity of 462 pcs with "turnkey" size of 3.2 mm were placed in the copper matrix. The tin-containing rod is placed in the centre of the matrix. The copper matrix with the hexagonal rods installed therein was enclosed in a double-layer diffusion barrier, the inner layer of which was made of Nb-Ta alloy, and the outer one was made of pure niobium. The blank was drawn to "turnkey" size of 3.8 mm.

### INDUSTRIAL APPLICABILITY

On a wire produced using a set of blanks, the critical current density in the cross section without copper is 2942 A/mm2 in the magnetic field with induction of 12 T at temperature of 4.2 K. The wire length was more than 700 m.

Therefore, use of the blank according to the present invention makes it possible to obtain a long superconductive composite wire with high current carrying capability.

## Claims

1. A blank for producing a long Nb₃Sn-based superconducting wire comprising a copper jacket (1) accommodating copper matrix (2) having a tin-containing rod (3) at its centre with a plurality of rods each having a copper-clad (4) arranged therearound, wherein the copper matrix (2) is surrounded by a multi-layer niobium diffusion barrier (5), **characterized in that** the plurality of rods comprises rods (6) containing an Nb-Ti alloy and rods (7) made of an Nb-Zr alloy, wherein each rod (7) made of an Nb-Zr alloy being a composite made from Nb-Zr alloy in the form of a core (8) surrounded by a niobium barrier (9).

2. The blank for producing a long Nb₃Sn-based superconducting wire according to claim 1, wherein the rods (7) made of an Nb-Zr alloy surround a tin-containing rod (3) and at the inner side of the diffusion barrier (5).

3. The blank for producing a long Nb₃Sn-based superconducting wire according to claim 1, wherein the niobium diffusion barrier (5) consists of two layers, wherein an inner layer of the niobium diffusion barrier (5) is made of niobium alloy, and an outer layer of the niobium diffusion barrier is made of niobium.

4. The blank for producing a long Nb₃Sn-based superconducting wire according to claim 1, wherein the niobium diffusion barrier (5) consists of two layers, wherein an inner layer of the niobium diffusion barrier (5) is made of niobium, and an outer layer of the niobium diffusion barrier (5) is made of niobium alloy.

## Patentansprüche

1. Eine Vorform zur Herstellung eines langen Supraleiterdrahtes auf Nb₃Sn-Basis, bestehend aus einer Kupferhülle (1), die mit einer Kupfermatrix (2) versorgt ist, in deren Mitte sich ein zinnhaltiger Stab (3) mit Mehrzahl von Stäben befindet, jeder Stab ist von einer Kupferhülle (4) umgeben, wobei die Kupfermatrix (2) von einer mehrschichtigen Niob-Diffusionsbarriere (5) umgeben ist, **dadurch gekennzeichnet, dass** die Mehrzahl von Stäben aus Nb-Ti-legierten Stäben (6) und Nb-Zr-legierten Stäben (7) besteht, wobei jeder Stab (7) aus Nb-Zr-Legierung einen Verbund aus Nb-Zr-Legierung in Form eines von der Niobbarriere (9) umgebenen Kerns (8) darstellt.

2. Die Vorform zur Herstellung eines langen Supraleiterdrahtes auf Nb₃Sn-Basis nach Anspruch 1, wobei die Nb-Zr-Legierungsstäbe (7) den zinnhaltigen Stab (3) und von innen die Diffusionsbarriere (5) umgeben.

3. Die Vorform zur Herstellung eines langen Supraleiterdrahtes auf Nb₃Sn-Basis nach Anspruch 1, wobei die Niob-Diffusionsbarriere (5) aus zwei Schichten besteht, wobei die innere Schicht der Niob-Diffusionsbarriere (5) aus Niob-Legierung und die äußere Schicht der Niob-Diffusionsbarriere aus Niob ausgeführt ist.

4. Die Vorform zur Herstellung eines langen Supraleiterdrahtes auf Nb₃Sn-Basis nach Anspruch 1, wobei die Niob-Diffusionsbarriere (5) aus zwei Schichten besteht, wobei die innere Schicht der Niob-Diffusionsbarriere (5) aus Niob und die äußere Schicht der Niob-Diffusionsbarriere (5) aus Niob-Legierung ausgeführt ist.

## Revendications

1. Un demiproduit pour la fabrication d'un fil supraconducteur de grande longueur sur base de Nb₃Sn qui inclut un revêtement de cuivre (1) contenant, à son tour, une matrice de cuivre (2) au centre de laquelle une tige stannifère est placée (3) avec plusieures tiges dont chacune a un revêtement de cuivre (4) placé autour de lui, en cela chaque matrice de cuivre (2) est entourée d'une barrière niobique multicouche de diffusion (5) qui se **caractérise par** ce que plusieures tiges incluent les tiges (6) qui contiennent l'alliage Nb-Ti et les tiges (7) de l'alliage Nb-Zr où chaque tige (7) de l'alliage Nb-Zr représente un matériau composite de l'alliage Nb-Zr en forme d'une tige (8) entourée d'une barrière niobique (9).

2. Un demiproduit pour la fabrication d'un fil supraconducteur de grande longueur sur base de Nb₃Sn selon le point 1, dans lequel les tiges (7) de l'alliage Nb-Zr entourent une tige stannifère (3) et la barrière de diffusion de côté intérieur (5).

3. Un demiproduit pour la fabrication d'un fil supraconducteur de grande longueur sur base de Nb₃Sn selon le point 1, dans lequel la barrière niobique de diffusion (5) se compose de deux couches où la couche intérieure de la barrière niobique de diffusion (5) est réalisée de l'alliage niobique, tandis que la couche extérieure de la barrière niobique de diffusion est réalisée en niobium.

4. Un demiproduit pour la fabrication d'un fil supraconducteur de grande longueur sur base de Nb₃Sn selon le point 1, dans lequel la barrière niobique de diffusion (5) se compose de deux couches où la couche intérieure de la barrière niobique de diffusion (5) est réalisée en niobium, tandis que la couche extérieure de la barrière niobique de diffusion (5) est réalisée de l'alliage niobique.
